# EUROPEAN PATENT APPLICATION

(11) **EP 4 586 778 A1**
(43) Date of publication of application: **16.07.2025**
(21) Application number: 23891063.2
(22) Date of filing: 24.04.2023
(51) Int. Cl.: H10K 30/50, H10K 30/81, H10K 50/814, H10K 50/824

(54) **CONDUCTIVE SUBSTRATE**

(30) Priority: 14.11.2022 JP 2022181712
(71) Applicant: Panasonic Intellectual Property Management Co., Ltd., Kadoma-shi, Osaka 571-0057 (JP)
(72) Inventor: HARITANI, Takeshi, Kadoma-shi, Osaka 571-0057 (JP); FUJII, Shoji, Kadoma-shi, Osaka 571-0057 (JP)
(74) Representative: Grünecker Patent- und Rechtsanwälte PartG mbB
(86) International application number: PCT/JP2023/016135
(87) International publication number: WO 2024/105901

(57) **Abstract**

A conductive substrate (1) includes a substrate (2) including a flat surface (2a), a first electrode (6), and an intermediate conductive layer (8). The first electrode (6) includes a plurality of conductive lines (7) each made of a conductive metal embedded in part of the substrate (2) that is near the flat surface (2a). The intermediate conductive layer (8) is formed as a thin film with a uniform thickness, and has a resistance value that is higher than a resistance value of each of the plurality of conductive lines (7). The surface of each conductive line (7) is substantially flush with the flat surface (2a) of the substrate (2).

## Description

### TECHNICAL FIELD

The present disclosure relates to a conductive substrate.

### BACKGROUND ART

A traditional conductive substrate used for a solar cell, an organic light emitting diode (OLED), a dimming device, and the like is known. For example, a conductive substrate of Patent Document 1 used for a solar cell is known.

Patent Document 1 discloses an organic thin-film solar cell using a transparent resin film. For example, the organic thin-film solar cell shown in FIG. 7 of Patent Document 1 includes a transparent substrate made of a transparent resin film, a mesh electrode formed on the transparent substrate, a transparent electrode formed on the transparent substrate, a hole extraction layer formed on the transparent electrode, a photoelectric conversion layer formed on the hole extraction layer, an electron extraction layer formed on the photoelectric conversion layer, and a counter electrode formed on the electron extraction layer.

### CITATION LIST

### PATENT DOCUMENT

Patent Document 1: Japanese Unexamined Patent Publication No. 2010-157681

### SUMMARY OF THE INVENTION

### TECHNICAL PROBLEM

In the above organic thin-film solar cell, the mesh electrode protrudes from the upper surface of the transparent substrate toward where the counter electrode is located. Part of the transparent electrode that corresponds to the position of each mesh electrode has a raised shape in cross-sectional view while covering each mesh electrode. Then, the transparent electrode is extremely thin on and around the corner portion of each mesh electrode that corresponds to the raised shape.

If the transparent electrode is thin as described above, the corner portion itself and portion around it of each mesh electrode is less likely to be covered with the transparent electrode, and in particular, the corner portion itself and portion around it of each mesh electrode is more likely to be exposed. Thus, the transparent electrode might be divided on and around the corner portion of each mesh electrode in the longitudinal direction of the raised shape. In this case, the function of the transparent electrode is impaired.

In addition, if the transparent electrode, the hole extraction layer, the photoelectric conversion layer, and the electron extraction layer are thin, each layer might be divided in the longitudinal direction of the raised shape from the corner portion of each mesh electrode. In this case, the function of each layer is impaired. Further, if each layer is divided, all the layers from the transparent electrode surrounding each mesh electrode to the counter electrode can slip off toward the transparent substrate, and the distance between the counter electrode formed on the electron extraction layer and the corner portion of each mesh electrode might be shortened. In this case, the counter electrode and the corner portion of each mesh electrode can come into contact with each other, which might cause an electrical short circuit.

In this manner, the configuration of Patent Document 1 might impair the original function of the device for which the conductive substrate is used.

In view of the foregoing, an object of the present disclosure is to avoid impairing the original function of a device for which the conductive substrate is used.

### SOLUTION TO THE PROBLEM

In order to achieve the object, one embodiment of the present disclosure is directed to a conductive substrate used to attach a functional layer and a second electrode, including: a substrate including a flat surface; a first electrode formed on the substrate; and an intermediate conductive layer stacked on the substrate, having conductivity, and having a carrier path for an electron or a hole. The first electrode includes a plurality of conductive lines each made of a conductive metal embedded in part of the substrate that is near the flat surface. The intermediate conductive layer is formed as a thin film with a uniform thickness, and has a resistance value that is higher than a resistance value of each of the plurality of conductive lines. A surface of the intermediate conductive layer that is opposite to another surface of the intermediate conductive layer that is in contact with the flat surface of the substrate is configured so that the functional layer and the second electrode can be arranged on the surface of the intermediate conductive layer. The surface of each of the plurality of conductive lines is substantially flush with the flat surface.

### ADVANTAGES OF THE INVENTION

According to the present disclosure, it is possible to avoid impairing the original function of the device for which the conductive substrate is used.

### BRIEF DESCRIPTION OF THE DRAWINGS

FIG. 1 is a partially enlarged plan view of a conductive member including a conductive substrate according to an embodiment of the present disclosure, where part of a conductor pattern is schematically enlarged.
FIG. 2 is a cross-sectional view taken along line II-II of FIG. 1.
FIG. 3 is a partially enlarged cross-sectional view of the area III of FIG. 2, and schematically shows carrier paths that appear when the conductive member including the conductive substrate is used for a solar cell.
FIG. 4 is a schematically enlarged diagram showing that the flat surface of the substrate and the surface of the conductive line are flush with each other.
FIG. 5 corresponds to FIG. 3 and schematically shows carrier paths that appear when the conductive member including the conductive substrate is used for an OLED according to a first variation of the embodiment.
FIG. 6 corresponds to FIG. 3 and schematically shows carrier paths that appear when the conductive member including the conductive substrate is used for a dimming device according to a second variation of the embodiment.
FIG. 7 is a schematically enlarged diagram showing that the surface of the conductive line is recessed downward below the flat surface of the substrate according to a third variation of the embodiment.
FIG. 8 corresponds to FIG. 1 and is a schematically enlarged view of part of a conductor pattern different from the conductor pattern of FIG. 1 according to a fourth variation of the embodiment.
FIG. 9 corresponds to FIG. 3 and schematically shows a cross-sectional structure of a conductive member that includes a conductive substrate provided with a first electrode and a conductive substrate provided with a second electrode according to a fifth variation of the embodiment.

### DESCRIPTION OF EMBODIMENTS

Embodiments of the present disclosure will now be described in detail with reference to the drawings. Note that the following description of the embodiment is merely an example in nature, and is not intended to limit the scope, applications, or use of the present disclosure.

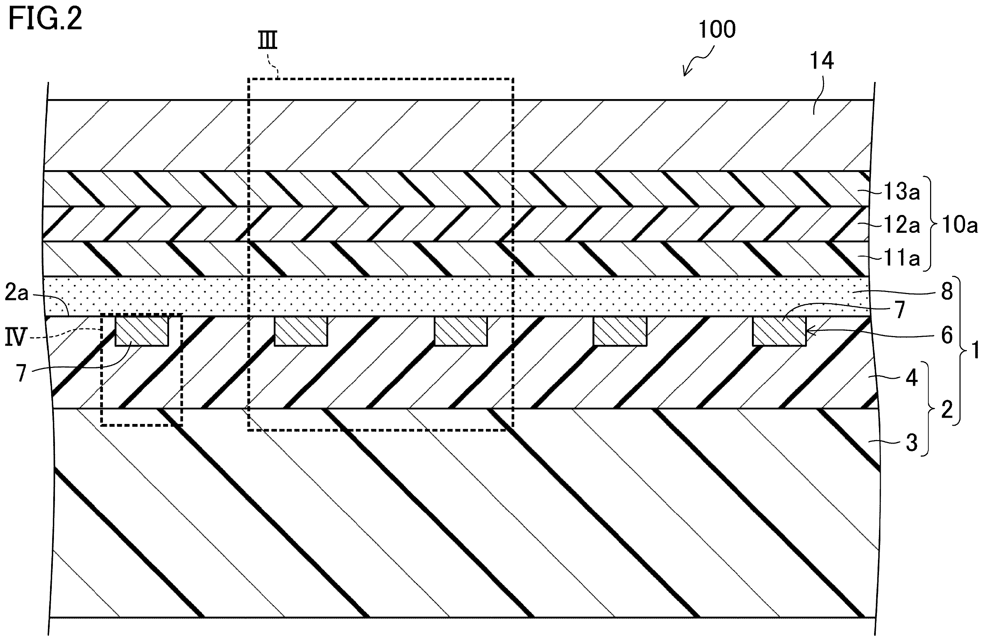

An embodiment of the present disclosure is directed to a conductive substrate 1 that is used to attach a functional layer 10a and a second electrode 14 (see FIG. 2). As shown in FIG. 2, the conductive substrate 1 includes a substrate 2, a first electrode 6, and an intermediate conductive layer 8. The conductive substrate 1 is disposed below the functional layer 10a (or disposed near the lower surface of a hole transport layer 11a described later).

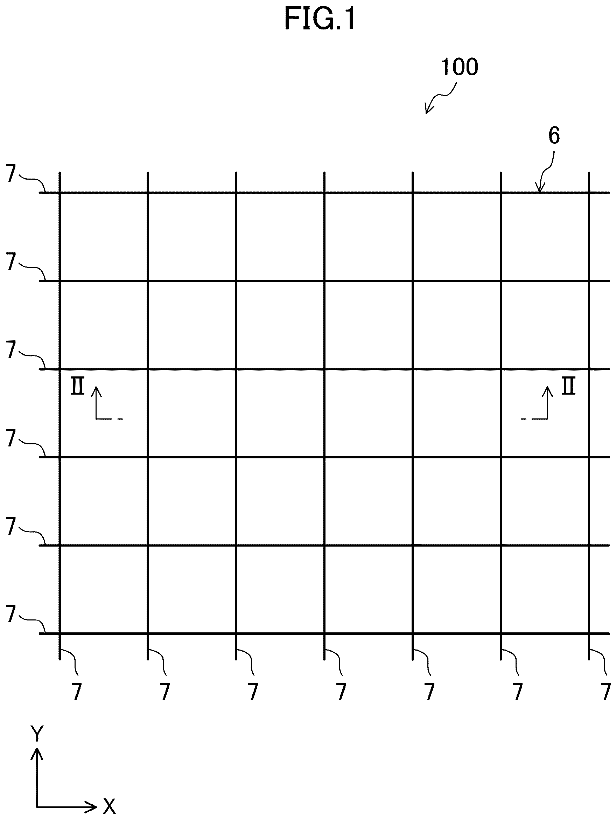

FIG. 1 schematically shows part of a conductive member 100. As shown in FIG. 2, the conductive member 100 includes the conductive substrate 1, the functional layer 10a, and the second electrode 14. The conductive member 100 can be used for a solar cell, an organic light emitting diode (OLED), a dimming device, and the like. This embodiment is an example embodiment in which the conductive member 100 is used for a solar cell.

Here, the direction from left to right on the sheet of FIG. 1 is defined as the "X direction," and the direction from bottom to top on the sheet of FIG. 1 is defined as the "Y direction."

In the following description, in the thickness direction of the conductive member 100 shown in FIG. 2, the side on which the second electrode 14 described later is located is defined as the "upper side" of the conductive member 100, and the opposite side (or the side on which a film base 3 described later is located) is defined as the "lower side" of the conductive member 100, whereby the positional relationship among the elements of the conductive member 100 will be defined. Note that this positional relationship is irrelevant to the actual directions for a device in which the conductive member 100 is incorporated.

### (Substrate)

As shown in FIG. 2, the substrate 2 has transparency and light-transmissive properties. The substrate 2 includes a flat surface 2a. In this embodiment, the flat surface 2a corresponds to an upper surface of a resin layer 4 described later.

The substrate 2 includes a film base 3. The film base 3 is made of a resin material with flexibility, transparency, and light-transmissive properties. The film base 3 has a thickness of 20 µm to 200 µm, for example.

Examples of the resin material include resin materials such as polyethylene terephthalate (PET), polycarbonate, a cycloolefin polymer (COP), and a cycloolefin copolymer (COC).

The substrate 2 includes the resin layer 4. The resin layer 4 is made of a resin material having insulating properties and light-transmissive properties. The resin layer 4 has a thickness of 1 µm to 10 µm, for example.

The resin layer 4 is stacked above the film base 3. The upper surface of the resin layer 4 (i.e., the flat surface 2a) is substantially flat except for a plurality of recesses 5 described later.

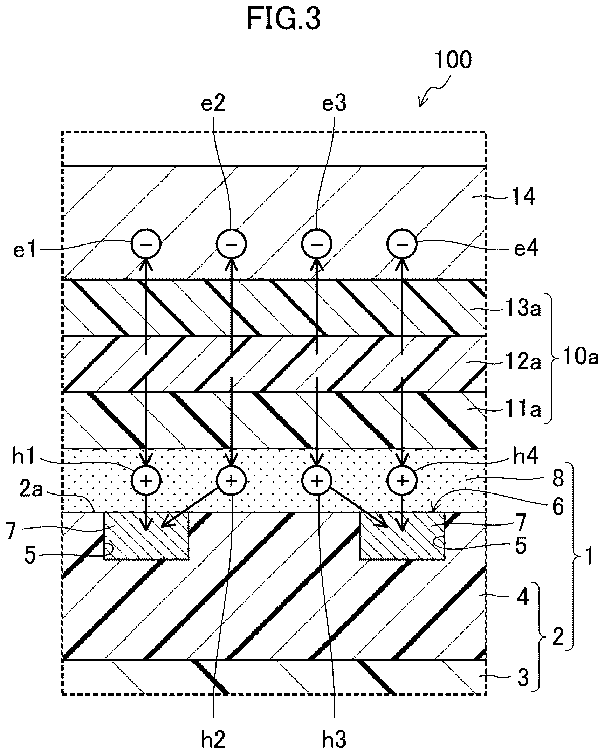

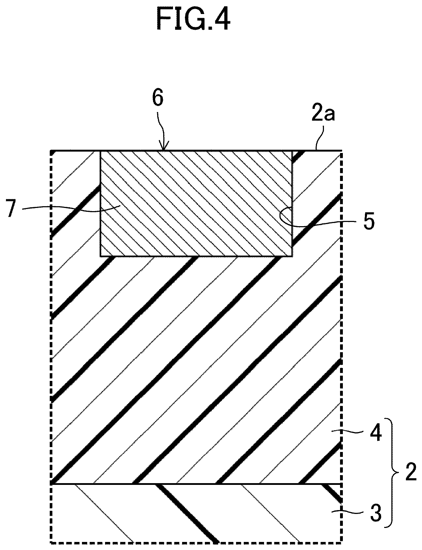

As shown in FIGS. 3 and 4, the resin layer 4 has the plurality of recesses 5, each having a bottom and recessed downward from the upper surface of the resin layer 4. The plurality of recesses 5 linearly extends on the upper surface of the resin layer 4 (the flat surface 2a) to form a predetermined pattern described later. The plurality of recesses 5 are formed on the upper surface of the resin layer 4 by hot embossing, an etching method by photolithography, laser machining, or the like.

### (First Electrode)

As shown in FIGS. 1 and 2, the first electrode 6 is configured as a conductor pattern formed near the flat surface 2a of the substrate 2 (or near the upper surface of the resin layer 4). The conductor pattern is formed by a plurality of conductive lines 7. The plurality of conductive lines 7 are disposed in part of the substrate 2 that is near the flat surface 2a.

The conductor pattern is arranged on the flat surface 2a of the substrate 2 to form a predetermined pattern. FIG. 1 shows a mesh pattern as an example of the predetermined pattern in which the plurality of conductive lines 7 are arranged in a mesh shape.

The mesh pattern is configured so that the plurality of conductive lines 7 extending in the X direction intersect with the plurality of conductive lines 7 extending in the Y direction. The plurality of conductive lines 7 extending in the X direction are arranged at equal intervals. The plurality of conductive lines 7 extending in the Y direction are arranged at equal intervals. In this embodiment, two conductive lines 7, 7 extending in the X direction and adjacent to each other and two conductive lines 7, 7 extending in the Y direction and adjacent to each other form one single cell with a square shape.

Each conductive line 7 is thin. Each conductive line 7 has a width of 10 µm or less, for example.

As shown in FIGS. 2 to 4, each conductive line 7 is made of a conductive metal embedded in the recess 5 of the substrate 2. Suitable examples of this conductive metal include copper (Cu), silver (Ag), gold (Au), aluminum (Al), nickel (Ni), and an alloy containing at least one of these metals.

The embodiment of the present disclosure is characterized in that the surface of each conductive line 7 is substantially flush with the flat surface 2a of the substrate 2 while being exposed from the flat surface 2a of the substrate 2. As shown in FIG. 4, in this embodiment, the flat surface 2a of the substrate 2 is completely flush with the surface of each conductive lines 7. In FIG. 4, the intermediate conductive layer 8 is not shown for convenience of illustration.

### (Intermediate Conductive Layer)

As shown in FIGS. 2 and 3, the intermediate conductive layer 8 is stacked on the flat surface 2a of the substrate 2. Specifically, the intermediate conductive layer 8 is disposed between the resin layer 4 and a hole transport layer 11a described later. As shown in FIG. 3, carrier paths for holes are formed in the intermediate conductive layer 8 of this embodiment. In FIGS. 2 and 3, the intermediate conductive layer 8 is dot-hatched in order to distinguish the intermediate conductive layer 8 from the other components.

The intermediate conductive layer 8 is formed as a thin film with a uniform thickness. The intermediate conductive layer 8 has a thickness of 3.0 µm or less. Preferably, the intermediate conductive layer 8 has a thickness of 1 µm or less. If the intermediate conductive layer 8 is made of indium tin oxide (ITO) described later, the intermediate conductive layer 8 has a thickness of about 0.02 µm (20 nm), for example. If the intermediate conductive layer 8 is made of PEDOT/PSS described later, the intermediate conductive layer 8 has a thickness of about 0.1 µm (100 nm), for example.

The intermediate conductive layer 8 has conductivity and transparency. Examples of the material of the intermediate conductive layer 8 include a metal oxide, a transparent conductive polymer, a transparent conductive ink, a conductive metal formed as an ultrathin film, a coating containing a π-conjugated conductive polymer, and a composition containing metal nanowires. The intermediate conductive layer 8 has a resistance value that is higher than the resistance value of each conductive line 7.

Examples of the metal oxide forming the intermediate conductive layer 8 include indium tin oxide (ITO) and indium zinc oxide (IZO).

The metal oxide may be a metal oxide such as a zinc oxide, an indium oxide, an antimony-doped tin oxide, a fluorine-doped tin oxide, an aluminum-doped zinc oxide, a potassium-doped zinc oxide, a silicon-doped zinc oxide, a zinc oxide-tin oxide-based metal oxide, an indium oxide-tin oxide-based metal oxide, or a zinc oxide-indium oxide-magnesium oxide-based metal oxide; or a composite material of two or more of these metal oxides.

Examples of the transparent conductive polymer include poly-3, 4-ethylenedioxythiophene/polysulfonic acid (PEDOT/PSS). Examples of the transparent conductive ink include an ink that contains a binder with carbon nanotubes or silver nanofibers.

Suitable examples of the conductive metal formed as an ultrathin film include copper (Cu), silver (Ag), gold (Au), aluminum (Al), nickel (Ni), and an alloy containing at least one of these metals. If the conductive metal formed as an ultrathin film is used as the material of the intermediate conductive layer 8, that metal is preferably formed as a thin film to the extent that its transparency is not impaired.

As shown in FIGS. 2 and 3, the intermediate conductive layer 8 is disposed above the plurality of conductive lines 7 located in part of the substrate 2 that is near the flat surface 2a. Due to this layout, the intermediate conductive layer 8 functions as a barrier layer for protecting the plurality of conductive lines 7. The plurality of conductive lines 7 are protected by the intermediate conductive layer 8, whereby the environmental durability and reliability of the conductive substrate 1 are improved.

In order to allow the intermediate conductive layer 8 to function as a barrier layer, the thickness of the intermediate conductive layer 8 is preferably set as follows according to the material for the intermediate conductive layer 8.

For example, if the intermediate conductive layer 8 is made of "non-crystalline" indium tin oxide (ITO), the thickness of the intermediate conductive layer 8 is preferably set to 20 nm or more and 100 nm or less. Here, if the thickness of the intermediate conductive layer 8 made of "non-crystalline" ITO is 20 nm, the surface resistivity of the intermediate conductive layer 8 that is converted from the value of that thickness is approximately 500 Ω/□. On the other hand, if the thickness of the intermediate conductive layer 8 is 100 nm, the surface resistivity of the intermediate conductive layer 8 that is converted from the value of that thickness is approximately 100 Ω/□. That is, if the intermediate conductive layer 8 is made of "non-crystalline" ITO, and the thickness of the intermediate conductive layer 8 is set to 20 nm or more and 100 nm or less, the surface resistivity of the intermediate conductive layer 8 is 100 Ω/□ or more and 500 Ω/□ or less. In the present disclosure, the term "non-crystalline" refers to the crystalline state in which the degree of crystallinity is relatively low (specifically, the crystalline state in which the degree of crystallinity is 5% or less).

Further, for example, if the intermediate conductive layer 8 is made of "crystalline" indium tin oxide (ITO), the thickness of the intermediate conductive layer 8 is preferably set to 20 nm or more and 60 nm or less. Here, if the thickness of the intermediate conductive layer 8 made of "crystalline" ITO is 20 nm, the surface resistivity of the intermediate conductive layer 8 that is converted from the value of that thickness is approximately 150 Ω/□. On the other hand, if the thickness of the intermediate conductive layer 8 is 60 nm, the surface resistivity of the intermediate conductive layer 8 that is converted from the value of that thickness is approximately 50 Ω/□. That is, if the intermediate conductive layer 8 is made of "crystalline" ITO, and the thickness of the intermediate conductive layer 8 is set to 20 nm or more and 60 nm or less, the surface resistivity of the intermediate conductive layer 8 is 50 Ω/□ or more and 150 Ω/□ or less. In the present disclosure, the term "crystalline" refers to the crystalline state in which the degree of crystallinity is relatively high (specifically, the crystalline state in which the degree of crystallinity is 70% or more).

Further, for example, if the intermediate conductive layer 8 is made of PEDOT/PSS, the thickness of the intermediate conductive layer 8 is preferably set to 100 nm or more and 300 nm or less.

As described above, the thickness of the intermediate conductive layer 8 is set as appropriate according to the material for the intermediate conductive layer 8, whereby the intermediate conductive layer 8 can function as a barrier layer. This intermediate conductive layer 8 allows each conductive line 7 to be less affected by the impurities, and thus each conductive line 7 is less likely to corrode. As a result, the environmental durability and reliability of the conductive substrate 1 are improved.

If the intermediate conductive layer 8 is made of indium tin oxide (ITO), the intermediate conductive layer 8 using the "crystalline" ITO is more likely to have a dense film structure than using the "non-crystalline" ITO. Thus, if the material of the intermediate conductive layer 8 is the "crystalline" ITO as described above, the environmental durability and reliability of the conductive substrate 1 are further improved.

### (Functional Layer)

As shown in FIGS. 2 and 3, the functional layer 10a includes three layers. Specifically, the functional layer 10a includes the hole transport layer 11a, a charge generation layer 12a, and an electron transport layer 13a. The hole transport layer 11a, the charge generation layer 12a, and the electron transport layer 13a are stacked in this order above the intermediate conductive layer 8. The functional layer 10a has a thickness of 3.0 µm or less. Preferably, the functional layer 10a has a thickness of 1.0 µm or less.

The charge generation layer 12a has an electron-donating function. Specifically, the charge generation layer 12a causes charge separation using a pn-junction formed in the charge generation layer 12a.

The charge generation layer 12a contains an electron-donating material. The electron-donating material is not particularly limited as long as it functions as an electron donor. Preferably, the electron-donating material is a material that can form a film by a wet coating method. In particular, a suitable example of the electron-donating material is an electron-donating conductive polymer material.

Examples of the electron-donating conductive polymer material include polyphenylene, polyphenylene vinylene, polysilane, polythiophene, polycarbazole, polyvinylcarbazole, porphyrin, polyacetylene, polypyrrole, polyaniline, polyfluorene, polyvinylpyrene, polyvinyl anthracene, derivatives thereof, copolymers thereof, a phthalocyanine-containing polymer, a carbazole-containing polymer, and an organometallic polymer.

More preferably, examples of the electron-donating conductive polymer material include a thiophene-fluorene copolymer, polyalkylthiophene, a phenyleneethynylene-phenylenevinylene copolymer, a phenyleneethynylene-thiophene copolymer, a phenyleneethynylene-fluorene copolymer, a fluorene-phenylenevinylene copolymer, and a thiophene-phenylenevinylene copolymer.

The hole transport layer 11a has a function of transporting holes generated by the charge generation layer 12a toward each conductive line 7. The hole transport layer 11a enhances the efficiency of transportation of holes generated by the charge generation layer 12a. As a result, the efficiency of photoelectric conversion in the conductive member 100 used for a solar cell is improved.

Suitable examples of the material of the hole transport layer 11a include doped conductive organic compounds such as polyaniline, polyphenylene vinylene, polythiophene, polypyrrole, polyparaphenylene, polyacetylene, and triphenyldiamine (TPD); and organic materials that form a charge transfer complex consisting of an electron-donating compound such as tetrathiofulvalene or tetramethylphenylenediamine and an electron-accepting compound such as tetracyanoquinodimethane or tetracyanoethylene.

The hole transport layer 11a may be a thin film made of a metal material such as Au, In, Ag, or Pd. The thin film may be made of one single metal material such as Au, In, Ag, or Pd, or may be made of any combination of those metal materials and the above organic materials.

The electron transport layer 13a has a function of transporting electrons generated by the charge generation layer 12a toward the second electrode 14 described later. The electron transport layer 13a enhances the efficiency of transportation of electrons generated by the charge generation layer 12a. As a result, the efficiency of photoelectric conversion in the conductive member 100 used for a solar cell is improved.

Suitable examples of the material of the electron transport layer 13a include doped conductive organic compounds such as polyaniline, polyphenylene vinylene, polythiophene, polypyrrole, polyparaphenylene, polyacetylene, and triphenyldiamine (TPD); and organic materials that form a charge transfer complex consisting of an electron-donating compound such as tetrathiofulvalene or tetramethylphenylenediamine and an electron-accepting compound such as tetracyanoquinodimethane or tetracyanoethylene.

The material of the electron transport layer 13a may be a metal-doped layer with an alkali metal or an alkaline earth metal. Examples of the metal-doped layer include bathocuproine (BCP) or bathophenanthoron (Bphen), Li, Cs, Ba, Sr, and the like.

### (Second Electrode)

As shown in FIGS. 2 and 3, the second electrode 14 is stacked on the upper surface of the functional layer 10a (or the upper surface of the electron transport layer 13a). That is, the second electrode 14 faces the first electrode 6 and the intermediate conductive layer 8 with the functional layer 10a sandwiched therebetween in the thickness direction of the substrate 2.

In this embodiment, the second electrode 14 is made of a metal material having conductivity. Examples of the metal material may include Li, In, Al, Ca, Mg, Sm, Tb, Yb, Zr, LiF, Au, and Ag. The second electrode 14 may be made of a metal oxide such as indium tin oxide (ITO) or indium zinc oxide (IZO), or a transparent conductive polymer such as PEDOT/PSS.

In this embodiment, the second electrode 14 is a metal layer configured as a single layer (see FIGS. 2 and 3). The second electrode 14 is formed by a vacuum deposition method or a pattern deposition method using a metal mask, for example. The second electrode 14 may consists a plurality of stacked layers, each of which is made of a different metal material. The second electrode 14 may be a solid electrode formed on the entire upper surface of the charge generation layer 12a, or may be configured as thin metal wires formed in a predetermined pattern.

### (Carrier Path)

Next, optimization of carrier paths in a situation in which the conductive member 100 is used for a solar cell will be briefly described with reference to FIG. 3.

The charge generation layer 12a generates carriers (electrons and holes) by light energy. The electrons (reference characters e1 to e4 in FIG. 3) generated by the charge generation layer 12a are transported toward the second electrode 14 via the electron transport layer 13a. The holes (reference characters h1 to h4 in FIG. 3) generated by the charge generation layer 12a are transported toward the first electrode 6 via the hole transport layer 11a and the intermediate conductive layer 8.

As described above, the intermediate conductive layer 8 is formed as a thin film with a uniform thickness. Thus, in the plane direction of the intermediate conductive layer 8, the holes are not locally dense and are uniformly transported from the charge generation layer 12a toward the intermediate conductive layer 8 via the hole transport layer 11a. Further, the intermediate conductive layer 8 has conductivity, and has a resistance value that is higher than the resistance value of each conductive line 7. In particular, the intermediate conductive layer 8 has higher conductivity than the hole transport layer 11a. Thus, the holes generated by the charge generation layer 12a are more easily transported from the charge generation layer 12a toward the first electrode 6 (the plurality of conductive lines 7) via the hole transport layer 11a and the intermediate conductive layer 8.

Here, a configuration in which the conductive member does not include the intermediate conductive layer 8 (an optional configuration (not shown) different from the configuration in which the conductive member 100 includes the conductive substrate 1 of the embodiment of the present disclosure) is considered. In this case, the holes generated by a charge generation layer (a layer corresponding to the reference character 12a in FIG. 3) move to a plurality of conductive lines (a configuration corresponding to the reference character 7 in FIG. 3) spaced apart from one another on the upper surface of a substrate via a hole transport layer (a layer corresponding to the reference character 11a in FIG. 3) with relatively low conductivity. Thus, for example, if the holes generated by the charge generation layer at an intermediate position between the conductive lines adjacent to each other (the holes corresponding to the reference characters h2 and h3 in FIG. 3) are transported toward each conductive line, the carrier paths for the holes (or the paths through which the holes are transported from the charge generation layer toward each conductive line via the hole transport layer) are relatively long. As a result, the holes may be thermally inactivated in the process in which the holes are moving in the hole transport layer. In other words, according to the above optional configuration, the holes generated by the charge generation layer might not be efficiently extracted, and the power generation efficiency of the solar cell might not be sufficiently increased.

To address the foregoing, the conductive member 100 of the embodiment of the present disclosure includes the intermediate conductive layer 8 between the substrate 2 and the hole transport layer 11a. As described above, the holes move more easily in the intermediate conductive layer 8 with relatively high conductivity. Thus, the holes (the reference characters h2 and h3 in FIG. 3) generated by the charge generation layer 12a at an intermediate position between the conductive lines 7, 7 adjacent to each other move directly from the hole transport layer 11a toward the intermediate conductive layer 8, and then pass through the intermediate conductive layer 8 and reach each conductive line 7. In this manner, unlike the above optional configuration, the conductive member 100 enables the holes to be smoothly transported from the charge generation layer 12a toward each conductive line 7 of the first electrode 6. That is, the conductive member 100 optimizes the carrier paths for the holes (in this embodiment, the paths through which the holes are transported from the charge generation layer 12a toward each conductive line 7 via the hole transport layer 11a and the intermediate conductive layer 8). As a result, the power generation efficiency of the solar cell for which the conductive member 100 including the conductive substrate 1 is used can be sufficiently increased.

### [Advantages of Embodiment]

The conductive substrate 1 of the embodiment of the present disclosure is configured so that the surface of each conductive line 7 is substantially flush with the flat surface 2a. That is, each conductive line 7 is configured not to protrude from the flat surface 2a of the substrate 2. According to this configuration, the intermediate conductive layer 8 can be formed as a thin film with a uniform thickness. Unlike the configuration of the known art (for example, the configuration of Patent Document 1), each conductive line 7 of the conductive substrate 1 (the conductive member 100) does not have a raised shape. Accordingly, the intermediate conductive layer 8 does not have a raised shape, and thus the intermediate conductive layer 8 cannot be partially divided. Thus, even if the intermediate conductive layer 8 is thin, the thickness of the intermediate conductive layer 8 can be kept uniform.

In addition, unlike the configuration of the known art, even if the intermediate conductive layer 8 and the functional layer 10a are relatively thin, the intermediate conductive layer 8 and the functional layer 10a each cannot be divided in the thickness direction of the substrate 2 because each conductive line 7 does not have a raised shape. Further, since each layer cannot be divided, each conductive line 7 cannot come into contact with the second electrode 14, and thus electrical short circuits do not occur.

Thus, it is possible to avoid impairing the original function of the device (the solar cell in this embodiment) for which the conductive member 100 is used.

In addition, the conductive substrate 1 of the embodiment of the present disclosure includes the intermediate conductive layer 8, whereby the surface of the conductive metal (such as copper) forming each conductive line 7 of the first electrode 6 is less likely to corrode. That is, the intermediate conductive layer 8 has a function of reducing corrosion of the conductive metal forming each conductive line 7.

### [First Variation of Embodiment]

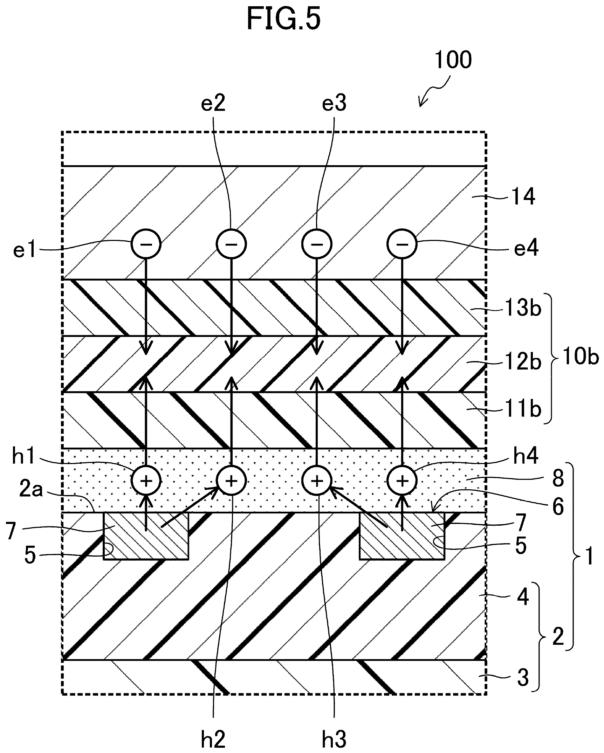

In the embodiment, the conductive member 100 is used for a solar cell, but the configuration is not limited thereto. For example, as shown in FIG. 5 as the first variation, the conductive member 100 may be used for an organic light emitting diode (OLED).

In the conductive member 100 of the first variation, the functional layer 10a is replaced with a functional layer 10b. As shown in FIG. 5, the functional layer 10b includes a hole transport layer 11b, a light emitting layer 12b, and an electron transport layer 13b. The hole transport layer 11b, the light emitting layer 12b, and the electron transport layer 13b are stacked in this order above the intermediate conductive layer 8. The second electrode 14 is stacked above the electron transport layer 13b. The functional layer 10b has a thickness of 3.0 µm or less. Preferably, the functional layer 10b has a thickness of 1.0 µm or less.

In the first variation, the electron transport layer 13b has a function of transporting electrons (reference characters e1 to e4 in FIG. 5) supplied from the second electrode 14 toward the light emitting layer 12b. The hole transport layer 11b has a function of transporting holes (reference characters h1 to h4 in FIG. 5) supplied from the first electrode 6 toward the light emitting layer 12b. In the light emitting layer 12b, the electrons supplied from the electron transport layer 13b and the holes supplied from the hole transport layer 11b are recombined together. The energy generated by recombination of the electrons and the holes excites the molecules that form the light emitting layer 12b, and accordingly the light emitting layer 12b has a function of emitting light.

Similarly to the embodiment, the conductive member 100 of the first variation includes the intermediate conductive layer 8 between the substrate 2 and the hole transport layer 11b. Accordingly, the carrier paths for the holes are optimized, thus enabling the holes to be smoothly transported from the plurality of conductive lines 7 forming the first electrode toward the light emitting layer 12b 6 via the intermediate conductive layer 8 and the hole transport layer 11b. As a result, the luminous efficiency of the solar cell for which the conductive member 100 is used can be sufficiently increased.

### [Second Variation of Embodiment]

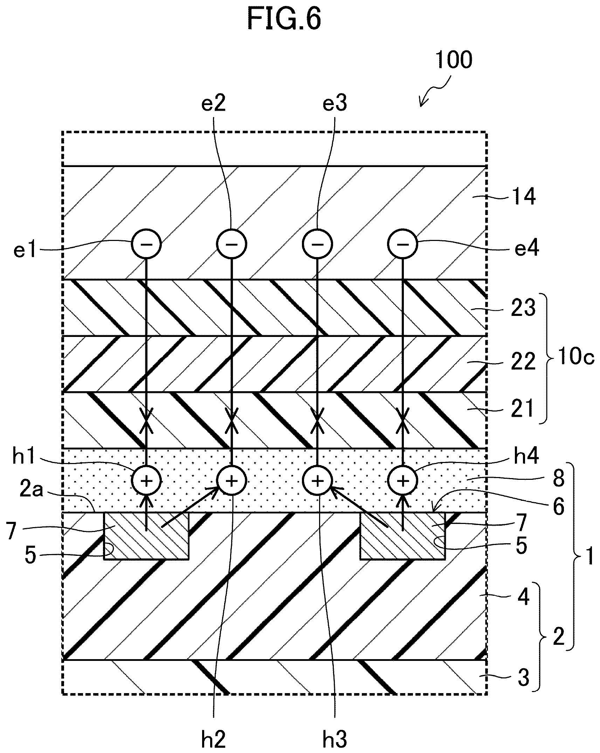

As shown in FIG. 6 as the second variation, the conductive member 100 may be used for a dimming device. In the conductive member 100 of the second variation, the functional layer 10a is replaced with a functional layer 10c. As shown in FIG. 6, in the second variation, the functional layer 10c includes an electrochromic layer 21, an electrolyte layer 22, and a counter electrode material layer 23. The electrochromic layer 21, the electrolyte layer 22, and the counter electrode material layer 23 are stacked in this order above the intermediate conductive layer 8. The functional layer 10c has a thickness of 3.0 µm or less. Preferably, the functional layer 10c has a thickness of 1.0 µm or less.

In the second variation, the second electrode 14 is stacked above the counter electrode material layer 23. The second electrode 14 of the second variation is made of a material with transparency. Examples of the material with transparency include the same material as the material of the intermediate conductive layer 8 described in the embodiment.

The electrochromic layer 21 has a function of coloring that is due to oxidation reaction induced by the holes supplied from the first electrode 6 (reference characters h1 to h4 in FIG. 6) and the electrons supplied from the second electrode 14 (reference characters e1 to e4 in FIG. 6). The counter electrode material layer 23 has a function of causing the reduction reaction against the oxidation reaction of the electrochromic layer 21 in order to stabilize the device. The electrolyte layer 22 has a function of blocking the electrons supplied from the second electrode 14 in order to prevent those electrons from escaping toward the second electrode 14 (or in the direction opposite to the first electrode 6).

The conductive member 100 of the second variation includes the intermediate conductive layer 8 between the substrate 2 and the electrochromic layer 21. Accordingly, the carrier paths for the holes are optimized, thus enabling the holes to be smoothly transported from the first electrode 6 (each conductive line 7) toward the electrochromic layer 21 via the intermediate conductive layer 8. As a result, the speed of chemical change, or the speed of color conversion, produced by the dimming device for which the conductive member 100 is can be sufficiently increased.

### [Third Variation of Embodiment]

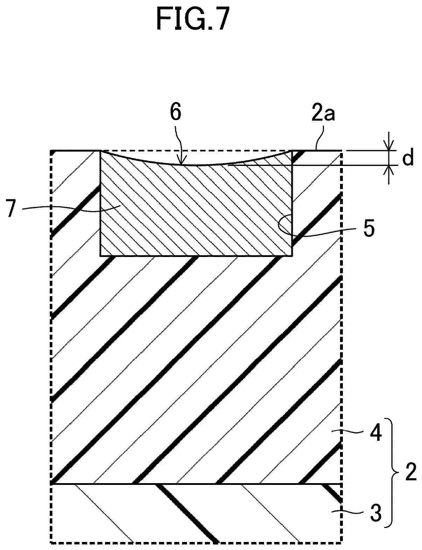

In the embodiment, the surface of the conductive line 7 is completely flush with the flat surface 2a of the substrate 2 (or the upper surface of the resin layer 4) (see FIG. 4), but the configuration is not limited thereto. That is, as shown in FIG. 7 as the third variation, the flat surface 2a of the substrate 2 does not have to be completely flush with the surface of conductive line 7. In FIG. 7, the intermediate conductive layer 8 is not shown for convenience of illustration.

As shown in FIG. 7, the surface of the conductive line 7 may be recessed downward below the flat surface 2a of the substrate 2 (or recessed toward the bottom of the recess 5). Specifically, in the conductive member 100 of the third variation, the distance between the flat surface 2a of the substrate 2 and the deepest part of the surface of the conductive line 7 (or the dimension d in FIG. 7) is preferably set to -1.0 µm or more and 1.0 µm or less. More preferably, the dimension d is -0.1 µm or more and 0.0 µm or less.

According to the dimension d set as described above, the flat surface 2a of the substrate 2 can be regarded as being substantially flush with the surface of the conductive line 7 similarly to the embodiment. That is, even according to the conductive member 100 of the third variation, each conductive line 7 does not protrude from the flat surface 2a similarly to the embodiment. Accordingly, the intermediate conductive layer 8 can be formed as a thin film with a uniform thickness. Thus, it is possible to avoid impairing the original function of the device for which the conductive member 100 of the third variation is used.

### [Fourth Variation of Embodiment]

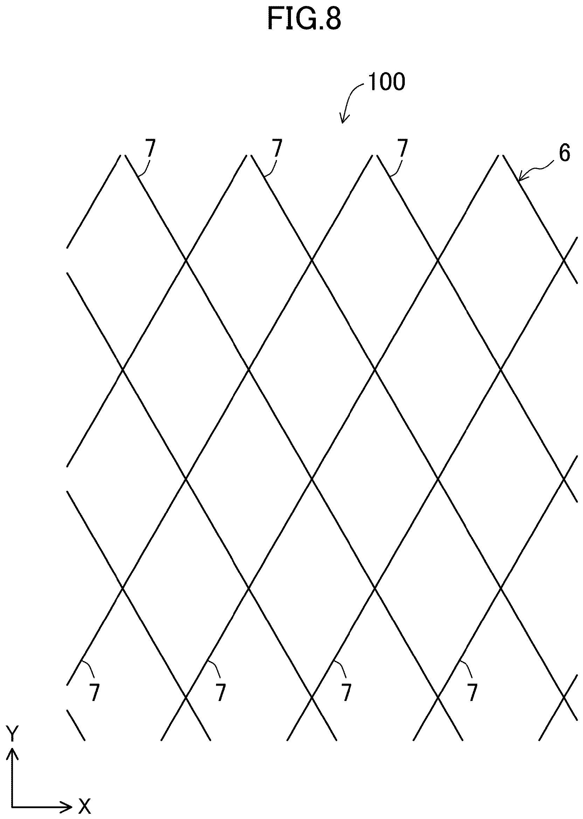

In the embodiment, in the first electrode 6, two conductive lines 7, 7 extending in the X direction and adjacent to each other and two conductive lines 7, 7 extending in the Y direction and adjacent to each other form one single cell with a square shape, but the configuration is not limited thereto. For example, as shown in FIG. 8 as the fourth variation, a plurality of conductive lines 7 may extend obliquely both in the X direction and in the Y direction so that four conductive lines 7 form one single cell with a diamond shape.

### [Fifth Variation of Embodiment]

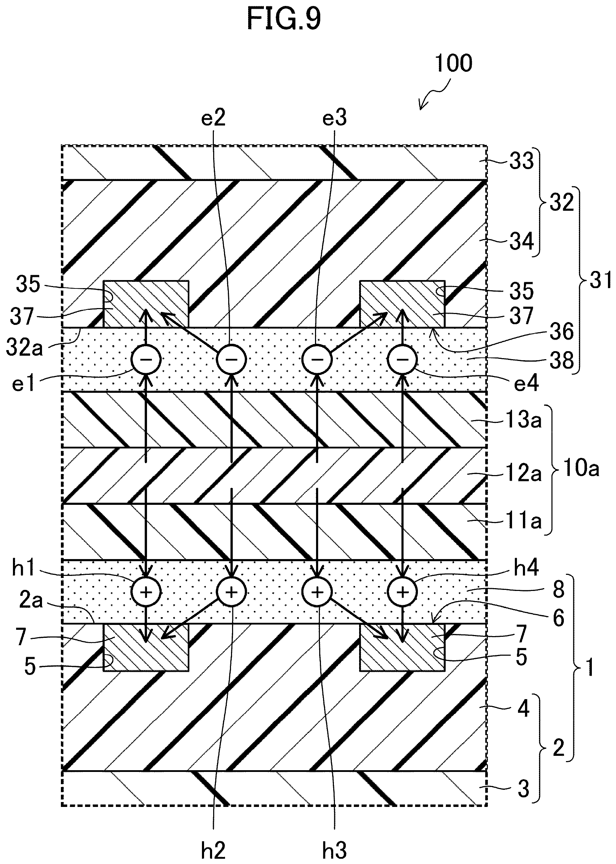

In the embodiment, the second electrode 14 is a metal layer configured as a single layer, but the configuration is not limited thereto. For example, instead of the second electrode 14 of the embodiment (see FIGS. 2 and 3), a conductive substrate 31 that includes a second electrode 36 may be provided as shown in FIG. 9 as the fifth variation. That is, the conductive member 100 of the fifth variation includes the conductive substrate 1 with the first electrode 6 and the conductive substrate 31 with the second electrode 36.

As shown in FIG. 9, the conductive substrate 31 includes a substrate 32, the second electrode 36, and an intermediate conductive layer 38. The substrate 32 includes a film base 33 and a resin layer 34. The substrate 32 includes a flat surface 32a. The flat surface 32a corresponds to the lower surface of the resin layer 34. The resin layer 34 has a plurality of recesses 35.

The film base 33, the resin layer 34, and the plurality of recesses 35 have substantially the same structure as the film base 3, the resin layer 4, and the recess 5 of the embodiment, respectively. Thus, the detailed descriptions of the film base 33, the resin layer 34, and the recess 35 are omitted.

The second electrode 36 is configured as a conductor pattern formed by a plurality of conductive lines 37. The plurality of conductive lines 37 are disposed in part of the substrate 32 that is near the flat surface 32a. Each conductive line 37 is made of a conductive metal embedded in each recess 35 of the resin layer 34. The conductive metal of the conductive lines 37 is the same material as the conductive metal of the conductive lines 7 described in the embodiment. The surface of each conductive line 37 is substantially flush with the flat surface 32a of the substrate 32 while being exposed from the flat surface 32a.

Although not shown, the surface of the conductive line 37 may be recessed upward above the flat surface 32a (or recessed toward the bottom of the recess 35). In this case, the distance between the flat surface 32a and the deepest part of the surface of the conductive line 37 is -1.0 µm or more and 1.0 µm or less. More preferably, the distance is -0.1 µm or more and 0.0 µm or less.

The intermediate conductive layer 38 is disposed between the electron transport layer 13a of the functional layer 10a and the second electrode 36. The configuration of the intermediate conductive layer 38 is similar to the configuration of the intermediate conductive layer 8 described in the embodiment. Carrier paths for electrons are formed in the intermediate conductive layer 38.

As described above, in the fifth variation, the conductive substrate 31 that has the same structure as that of the conductive substrate 1 of the embodiment is provided above the functional layer 10a, thus providing the same advantage as that of the conductive substrate 1 of the embodiment. That is, even if the intermediate conductive layer 38 is thin, the thickness of the intermediate conductive layer 38 can be kept uniform. In addition, the intermediate conductive layer 38 and the functional layer 10a cannot be divided in the thickness direction of the substrate 32. Thus, it is possible to avoid impairing the original function of the device for which the conductive member 100 of the fifth variation is used.

Although not shown, as another variation from the fifth variation, the conductive substrate 1 may be disposed above the functional layer 10a (or disposed near the upper surface of the electron transport layer 13a), and in contrast, the conductive substrate 31 may be disposed below the functional layer 10a (or disposed near the lower surface of the hole transport layer 11a). In this case, carrier paths for electrons are formed in the intermediate conductive layer 8, and in contrast, carrier paths for holes are formed in the intermediate conductive layer 38.

### [Other Embodiments]

In the embodiment and the first and second variations, the conductive substrate 1 including the first electrode 6 is disposed below the functional layer 10a, and in contrast, the second electrode 14 is disposed above the functional layer 10a, but the configuration is not limited thereto. That is, although not shown, the conductive substrate 1 including the first electrode 6 (which is disposed above the electron transport layer 13a in the embodiment) may be disposed above the functional layer 10a, and in contrast, the second electrode 14 (which is disposed above the hole transport layer 11a in the embodiment) is disposed below the functional layer 10a. In this embodiment, carrier paths for electrons are formed in the intermediate conductive layer 8.

### INDUSTRIAL APPLICABILITY

The conductive substrate of the present disclosure is an industrially applicable conductive substrate that can be used for a device such as a solar cell, an OLED, or a dimming device.

### DESCRIPTION OF REFERENCE CHARACTERS

- 1, 31: Conductive Substrate
- 2, 32: Substrate
- 2a, 32a: Flat Surface
- 3, 33: Film Base
- 4, 34: Resin Layer
- 5, 35: Recess
- 6: First Electrode
- 7, 37: Conductive Line
- 8, 38: Intermediate Conductive Layer
- 10a, 10b, 10c: Functional Layer
- 11a, 11b: Hole Transport Layer
- 12a: Charge Generation Layer
- 12b: Light Emitting Layer
- 13a, 13b: Electron Transport Layer
- 14, 36: Second Electrode
- 21: Electrochromic Layer
- 22: Electrolyte Layer
- 23: Counter Electrode Material Layer
- 100: Conductive Member

## Claims

1. A conductive substrate used to attach a functional layer and a second electrode, comprising:
a substrate including a flat surface;
a first electrode formed on the substrate; and
an intermediate conductive layer stacked on the substrate, having conductivity, and having a carrier path for an electron or a hole,
wherein
the first electrode includes a plurality of conductive lines each made of a conductive metal embedded in part of the substrate that is near the flat surface,
the intermediate conductive layer is formed as a thin film with a uniform thickness, and has a resistance value that is higher than a resistance value of each of the plurality of conductive lines,
a surface of the intermediate conductive layer that is opposite to another surface of the intermediate conductive layer that is in contact with the flat surface of the substrate is configured so that the functional layer and the second electrode can be arranged on the surface of the intermediate conductive layer, and
a surface of each of the plurality of conductive lines is substantially flush with the flat surface.

2. The conductive substrate of claim 1, wherein
a distance between the flat surface of the substrate and a deepest part of the surface of each of the plurality of conductive lines is -1.0 µm or more and 0.0 µm or less.

3. A conductive substrate used to attach a functional layer and a first electrode, comprising:
a substrate including a flat surface;
a second electrode formed on the substrate; and
an intermediate conductive layer stacked on the substrate, having conductivity, and having a carrier path for an electron or a hole,
wherein
the second electrode includes a plurality of conductive lines each embedded in part of the substrate that is near the flat surface,
the intermediate conductive layer is formed as a thin film with a uniform thickness, and has a resistance value that is higher than a resistance value of each of the plurality of conductive lines,
a surface of the intermediate conductive layer that is opposite to another surface of the intermediate conductive layer that is in contact with the flat surface of the substrate is configured so that the functional layer and the first electrode can be arranged on the surface of the intermediate conductive layer, and
a surface of each of the plurality of conductive lines is substantially flush with the flat surface.

4. The conductive substrate of claim 3, wherein
a distance between the flat surface of the substrate and a deepest part of the surface of each of the plurality of conductive lines is -1.0 µm or more and 0.0 µm or less.
